(19) Europäisches Patentamt
European Patent Office
Office européen des brevets

(11) **EP 4 757 567 A1**

(12) **EUROPEAN PATENT APPLICATION**
published in accordance with Art. 153(4) EPC

(43) Date of publication:
**10.06.2026 Bulletin 2026/24**

(21) Application number: **23948383.7**

(22) Date of filing: **04.08.2023**

(51) International Patent Classification (IPC):
**H10N 60/01** (2023.01)    **H10N 60/12** (2023.01)

(52) Cooperative Patent Classification (CPC):
**H10N 60/01; H10N 60/12**

(86) International application number:
**PCT/JP2023/028645**

(87) International publication number:
**WO 2025/032663 (13.02.2025 Gazette 2025/07)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **FUJITSU LIMITED**
**Kawasaki-shi, Kanagawa 211-8588 (JP)**

(72) Inventors:
• **ABE, Toru**
**Kawasaki-shi, Kanagawa 211-8588 (JP)**
• **SAIDA, Daisuke**
**Kawasaki-shi, Kanagawa 211-8588 (JP)**

(74) Representative: **Haseltine Lake Kempner LLP**
**One Portwall Square**
**Portwall Lane**
**Bristol BS1 6BH (GB)**

(54) **METHOD FOR MANUFACTURING QUANTUM DEVICE AND PROCESSING SYSTEM**

(57) The present invention provides a processing system including: a selection unit that selects, as an object of measurement from among three or more qubits constituting a basic unit, a first qubit with a relatively high frequency of errors that may occur when performing a gate operation for causing the energy level of a target qubit to transition to a prescribed state, the gate operation applying a control signal according to the operating frequency of the target qubit; a measurement unit that measures the resistance of a Josephson element of the first qubit; and an adjustment unit that adjusts the magnitude of the resistance of Josephson element of the first qubit on the basis of the measured value of the resistance.

FIG.14

```
        START
          │
┌─────────────────────────────────┐
│ SELECT SOME QUBITS HAVING        │
│ RELATIVELY HIGH FREQUENCY OF     │──  S1
│ ERRORS AMONG FOUR QUBITS         │
│ CONSTITUTING BASIC UNIT AS       │
│ OBJECT OF MEASUREMENT            │
└─────────────────────────────────┘
          │
┌─────────────────────────────────┐
│ MEASURE RESISTANCE OF JOSEPHSON  │──  S2
│ ELEMENT FOR SELECTED SOME QUBITS │
└─────────────────────────────────┘
          │
┌─────────────────────────────────┐
│ ADJUST MAGNITUDE OF RESISTANCE   │
│ OF JOSEPHSON ELEMENT FOR QUBIT   │──  S3
│ OF WHICH MEASURED VALUE IS NOT   │
│ WITHIN PREDETERMINED RANGE       │
└─────────────────────────────────┘
          │
         END
```

EP 4 757 567 A1

**Description**

FIELD

The disclosed technology relates to a method for manufacturing a quantum device and a processing system.

BACKGROUND

As a technique related to a method for manufacturing a quantum device, the following technique is known. For example, Patent Literature 1 describes a method including a step of annealing a Josephson junction of each of a plurality of qubits including the Josephson junction. By annealing the Josephson junction, the frequency of the qubit changes to the set point frequency.

Patent Literature 2 describes that an electromagnetic signal is radiated onto a set of capacitor pads of a Josephson junction of a superconducting qubit chip to heat the Josephson junction.

Prior Art Document

Patent Literature

Patent Literature 1: US Patent Application Publication No. 2019/0165244
Patent Literature 2: Japanese National-Phase Publication (JP-A) No. 2021-535592

SUMMARY OF INVENTION

Technical Problem

It is known that transmon is used as a qubit that constitutes a quantum device configured to perform quantum operation. The transmon has a configuration in which a Josephson element having a superconductor and a capacitor are connected in parallel, and performs quantum operation using nonlinear energy. In a bit-increased quantum computing device, a plurality of qubits is connected to each other via a capacitor.

In the quantum operation, a gate operation for transitioning an energy level of a qubit is performed by applying a control signal having a frequency equal to an operating frequency of the qubit. In a quantum device having a group of a plurality of qubits in which adjacent qubits are capacitively or inductively coupled as a basic unit, individual operation of the qubits becomes possible by making operating frequencies of the plurality of qubits constituting the basic unit different from each other.

When the operating frequency of any of the plurality of qubits constituting the basic unit deviates from the design value, an error may occur in which the gate operation is unstable. Since the operating frequency of the qubit is correlated with the resistance value of the Josephson element, the operating frequency of the qubit can be adjusted to approach the design value by adjusting the resistance value of the Josephson element.

Laser annealing is known as a technique for adjusting the resistance value of a Josephson element. The laser annealing is a technique of locally heating the Josephson junction with a laser to promote formation of an insulator layer and increase the resistance value of a Josephson element.

In order to suppress the occurrence of errors due to the deviation in the operating frequency, a method is conceivable in which the resistance of the Josephson element is measured for all the qubits constituting the quantum device, and laser annealing is performed for all the qubits whose resistance values are out of the allowable range. However, according to this method, the number of qubits to be subjected to laser annealing becomes enormous, and a large processing time is required.

The disclosed technology has been made in view of the above points, and an object thereof is to efficiently adjust an operating frequency of a qubit.

Solution to Problem

A manufacturing method according to the disclosed technology is a method for manufacturing a quantum device including, as a basic unit, a plurality of three or more qubits each including a Josephson element and having an operating frequency correlated with a magnitude of resistance of the Josephson element, the qubits having different operating frequencies from each other. This manufacturing method includes: a first step of selecting, as an object of measurement from among the plurality of qubits, a first qubit with a relatively high frequency of errors that occur when performing a gate operation for causing an energy level of a target qubit to transition to a prescribed state, the gate operation applying a control signal according to an operating frequency of the target qubit; a second step of measuring a resistance of the Josephson element of the first qubit selected in the first step from among the plurality of qubits; and a third step of adjusting a magnitude of the resistance of the Josephson element of the first qubit based on a measured value of the resistance.

Advantageous Effects of Invention

According to the disclosed technology, the operating frequency of the qubit can be efficiently adjusted.

BRIEF DESCRIPTION OF DRAWINGS

Fig. 1 is a plan view illustrating an example of a configuration of a quantum device according to an embodiment of the disclosed technology.

Fig. 2 is an enlarged view of one of basic units.

Fig. 3 is an equivalent circuit diagram of an operation block.

Fig. 4 is a diagram illustrating an energy level structure of a transmon.

Fig. 5 is a diagram illustrating an example of an operating frequency of each of four qubits constituting a basic unit.

Fig. 6 is a diagram illustrating an example of one-qubit operation.

Fig. 7A is a diagram illustrating a relationship between operating frequencies of four qubits constituting a basic unit.

Fig. 7B is a diagram illustrating the state illustrated in Fig. 7A by energy levels.

Fig. 8A is a diagram illustrating a relationship between operating frequencies of four qubits constituting a basic unit.

Fig. 8B illustrates the state illustrated in Fig. 8A by an energy level.

Fig. 9 is a diagram illustrating an example of two-qubit operation.

Fig. 10A is a diagram illustrating a relationship between operating frequencies of four qubits constituting a basic unit.

Fig. 10B illustrates the state illustrated in Fig. 10A by an energy level.

Fig. 11 is a block diagram illustrating an example of a functional configuration of a processing system according to an embodiment of the disclosed technology.

Fig. 12 is a diagram illustrating an example of an error occurrence frequency for each qubit.

Fig. 13 is a cross-sectional view schematically illustrating laser annealing for a Josephson element.

Fig. 14 is a flowchart illustrating an example of a flow of processing performed by the processing system.

Fig. 15 is a diagram illustrating a relationship between operating frequencies of four qubits constituting a basic unit and an amplification band of JPA.

Fig. 16 is a flowchart illustrating an example of a flow of processing performed by the processing system according to a second embodiment.

DESCRIPTION OF EMBODIMENTS

Hereinafter, an example of an embodiment of the disclosed technology will be described with reference to the drawings. In the drawings, the same or equivalent components and portions are denoted by the same reference numerals, and redundant description is omitted.

[First Embodiment]

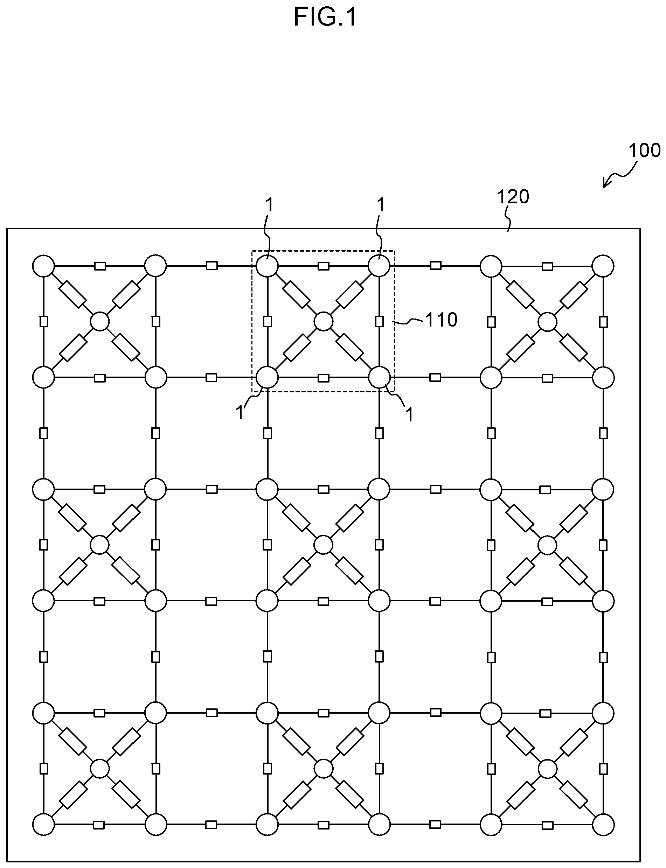

Fig. 1 is a plan view illustrating an example of a configuration of a quantum device 100 according to an embodiment of the disclosed technology. The quantum device 100 according to the present embodiment has four qubits 1 as a basic unit 110. The quantum device 100 has a plurality of basic units 110 disposed in a lattice pattern on a substrate 120.

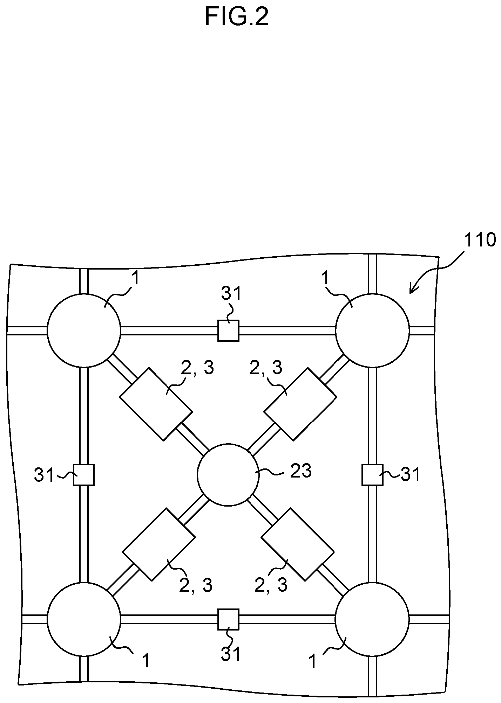

Fig. 2 is an enlarged view of one of the basic units 110 illustrated in Fig. 1. Four qubits 1 constituting one basic unit 110 are disposed at positions corresponding to four vertices of a square, and a readout electrode 23 is disposed at the center of the square. One readout electrode 23 is shared by four qubits 1. A resonator 2 and a filter 3 are provided on each path from the four qubits 1 to the readout electrode 23. Each qubit 1 is connected to another adjacent qubit 1 via a capacitor 31. Therefore, each qubit 1 creates a quantum entangled state with another adjacent qubit 1 and performs a quantum operation.

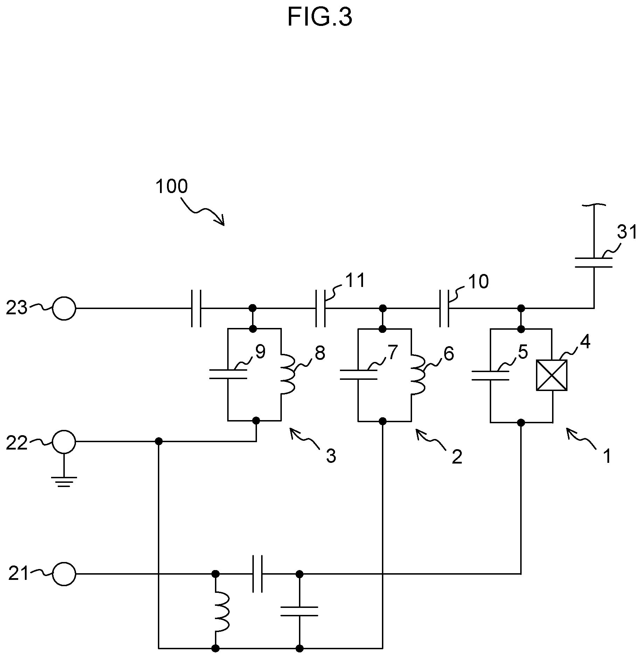

Fig. 3 is an equivalent circuit diagram of an operation block including one qubit 1, one resonator 2, and one filter 3. The qubit 1 is an element that forms a coherent two-level system using superconductivity and performs the quantum operation using nonlinear energy. The qubit 1 has a transmon in which a Josephson element 4 and a capacitor 5 are connected in parallel. The Josephson element 4 includes a pair of superconductor layers that exhibits superconductivity at a temperature equal to or lower than a predetermined critical temperature, and an ultrathin insulator layer having a thickness of about several nm sandwiched between the pair of superconductor layers. The superconductor layer may be, for example, aluminum, and the insulator layer may be, for example, aluminum oxide.

The resonator 2 is connected to the qubit 1 via a capacitor 10. The resonator 2 interacts with the qubit 1 to read out a response signal indicating the state of the qubit 1. The resonator 2 has a resonance circuit in which a superconducting inductor 6 and a capacitor 7 are connected in parallel. The filter 3 is connected to the resonator 2 via a capacitor 11. The filter 3 removes a noise component included in the response signal indicating the state of the qubit 1. Similarly to the resonator 2, the filter 3 has a resonance circuit in which a superconducting inductor 8 and a capacitor 9 are connected in parallel.

A control electrode 21, a ground electrode 22, and the readout electrode 23 are connected to the operation block. A control signal for controlling the qubit 1 is input to the control electrode 21. In Figs. 1 and 2, illustration of the control electrode 21 and the ground electrode 23 is omitted. The state of the qubit 1 is controlled by the control signal input to the control electrode 21. The response signal indicating the state of the qubit 1 is read from the readout electrode 23. A ground potential is externally applied to the ground electrode 22. The ground potential applied to the ground electrode 22 is supplied to each portion of the operation block.

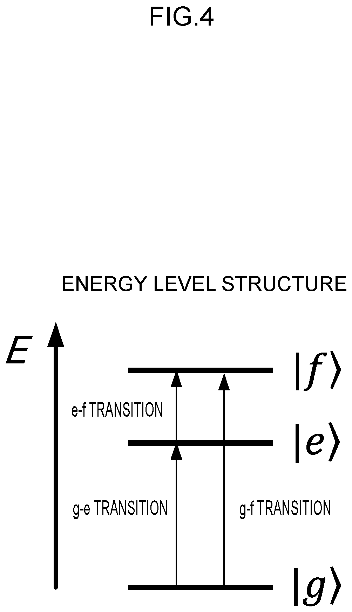

Fig. 4 is a diagram illustrating an energy level structure of the transmon constituting the qubit 1. The qubit 1 can have any energy level of a state g, a state e, and a state f. For example, the state g corresponds to a logical value "0", and the state e corresponds to a logical value "1". The state f is not used in the quantum operation. By applying a control signal having a frequency equal to the operating frequency of the qubit 1 to the control electrode 21, the state of the qubit 1 transitions. The transition from the state g to the state e is referred to as "g-e transition". The transition from the state g to the state f is referred to as "g-f transition". The transition from the state e to the state f is referred to as "e-f transition". The operating frequencies for causing the g-e transition, the g-f transition, and the e-f transition are different from each other.

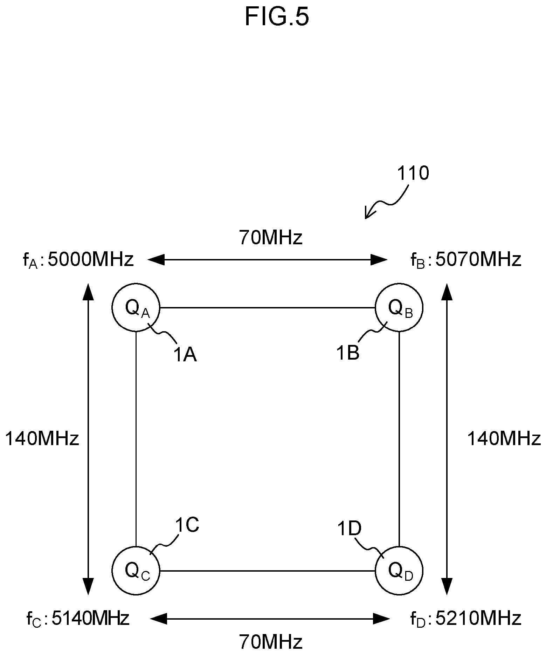

Fig. 5 is a diagram illustrating an example of the operating frequency of each of the four qubits $[Q_A]$1A, $[Q_B]$1B, $[Q_C]$1C, and $[Q_D]$1D constituting the basic unit 110. Note that the operating frequency illustrated in Fig. 5 corresponds to the g-e transition. In the example illustrated in Fig. 5, an operating frequency $f_A$ of the qubit $[Q_A]$1A is 5000 MHz, and an operating frequency $f_B$ of the qubit $[Q_B]$1B is 5070 MHz. The operating frequency $f_C$ of the qubit $[Q_C]$1C is 5140 MHz, and the operating frequency $f_D$ of the qubit $[Q_D]$1D is 5210 MHz. That is, $f_A \neq f_B \neq f_C \neq f_D$. In this way, by making the operating frequencies of the four qubits 1 constituting the basic unit 110 different from each other, individual operations of the four qubits $[Q_A]$1A, $[Q_B]$1B, $[Qc]$ 1C, and $[Q_D]$1D become possible.

When the operating frequency of any one of the four qubits 1 constituting the basic unit 110 deviates from the design value, an error may occur in which the gate operation is unstable. The gate operation and the error will be described below.

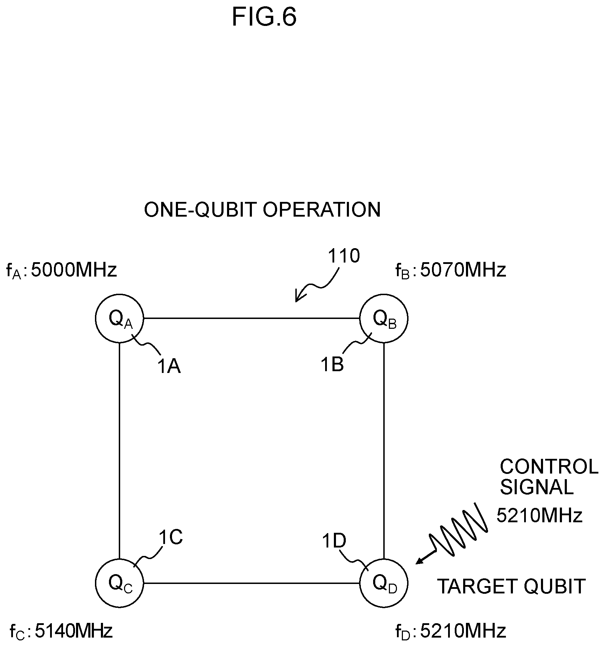

Fig. 6 is a diagram illustrating an example of one-qubit operation which is one of gate operations. The one-qubit operation is a gate operation of applying a control signal to a target qubit whose state is to be transitioned. Fig. 6 illustrates one-qubit operation using the qubit $[Q_D]$1D as a target qubit. A control signal of 5210 MHz equal to the operating frequency of the qubit $[Q_D]$1D is applied to the qubit $[Q_D]$1D which is the target qubit.

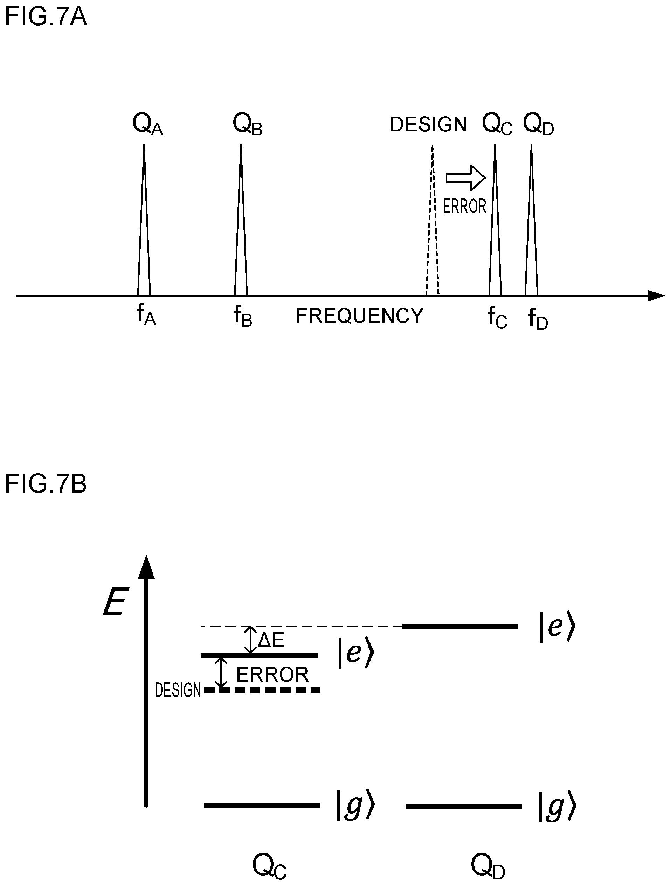

Fig. 7A illustrates the relationship between the operating frequencies of the four qubits $[Q_A]$1A, $[Q_B]$1B, $[Q_C]$1C, and $[Q_D]$1D constituting the basic unit 110, and illustrates a case where the operating frequency $f_C$ of the qubit $[Q_C]$1C deviates from the design value to the high frequency side due to manufacturing variations and the like. In this case, the operating frequency $f_C$ of the qubit $[Q_C]$1C and the operating frequency $f_D$ of the qubit $[Q_D]$1D adjacent to the qubit $[Q_C]$1C may be close to each other.

Fig. 7B illustrates the state illustrated in Fig. 7A by an energy level. The error of the operating frequency $f_C$ with respect to the design value appears as an error with respect to the design value at the energy level of the state e of the qubit $[Q_C]$. When the energy level of the state e of the qubit $[Qc]$ deviates from the design value, the difference $\Delta E$ between the energy level of the state e of the qubit $[Q_C]$ and the energy level of the state e of the qubit $[Q_D]$ may become excessively small. In this case, for example, in a case where the one-qubit operation using the qubit $[Q_C]$1C as the target qubit is performed, there is a possibility that an unintended state transition (g-e transition) occurs in the qubit $[Q_D]$ due to a leakage component of a control signal inevitably generated.

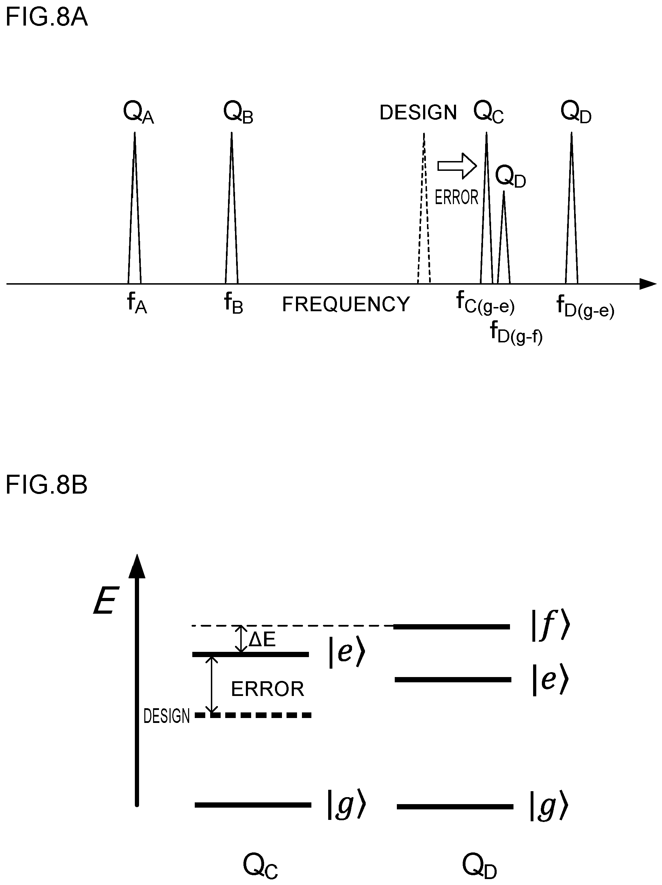

Meanwhile, Fig. 8A illustrates a case where the operating frequency $f_{C(g-e)}$ corresponding to the g-e transition of the qubit $[Qc]$1C and the operating frequency $f_{D(g-f)}$ corresponding to the g-f transition of the qubit $[Q_D]$1D are close to each other due to the deviation of the operating frequency $f_C$ of the qubit $[Q_C]$1C from the design value to the high frequency side.

Fig. 8B illustrates the state illustrated in Fig. 8A by an energy level. When the energy level of the state e of the qubit $[Q_C]$ deviates from the design value, the difference $\Delta E$ between the energy level of the state e of the qubit $[Q_C]$ and the energy level of the state f of the qubit $[Q_D]$ may become excessively small. In this case, for example, in a case where the one-qubit operation using the qubit $[Q_C]$1C as the target qubit is performed, there is a possibility that an unintended state transition (g-f transition) occurs in the qubit $[Q_D]$ due to a leakage component of a control signal inevitably generated.

As illustrated in Figs. 7A and 8A, in a case where the operating frequencies corresponding to respective state transitions between two qubits disposed adjacent to each other are excessively close to each other, an error in which the one-qubit operation is unstable may occur. This type of error is referred to as a "first error". Among the four qubits disposed at the positions corresponding to the four vertices of the square, two qubits disposed at both ends of each side of the square correspond to "two qubits disposed adjacent to each other".

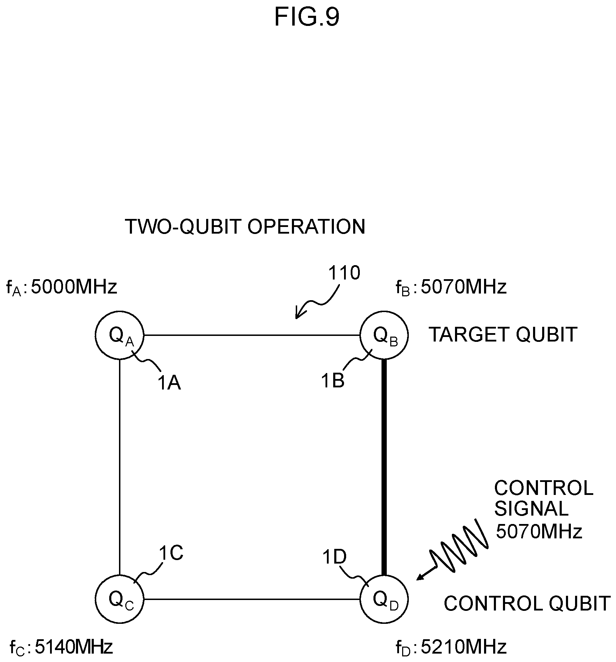

Fig. 9 is a diagram illustrating an example of a two-qubit operation which is one of gate operations. The two-qubit operation is a gate operation of applying a control signal to a control bit adjacent to a target qubit whose state is to be transitioned. Fig. 9 illustrates the two-qubit operation in which the qubit $[Q_B]$1B is the target qubit and the qubit $[Q_D]$1D is a control qubit. A control signal of 5070 MHz equal to the operating frequency of the qubit $[Q_B]$1B which is the target qubit is applied to the qubit $[Q_D]$1D which is the control qubit.

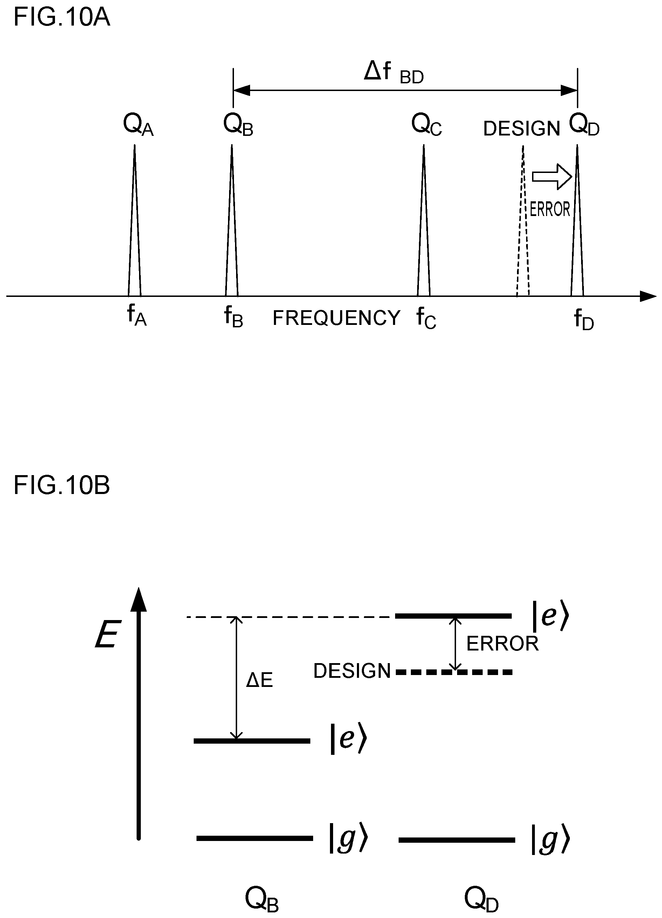

Fig. 10A illustrates the relationship between the operating frequencies of the four qubits $[Q_A]$1A, $[Q_B]$1B, $[Q_C]$1C, and $[Q_D]$1D constituting the basic unit 110, and illustrates a case where the operating frequency $f_D$ of the qubit $[Q_D]$1D deviates from the design value to the high frequency side due to manufacturing variations and the like. In this case, the difference $\Delta f_{BD}$ between the operating frequency $f_D$ of the qubit $[Q_D]$1D, which is the control qubit, and the operating frequency $f_B$ of the qubit $[Q_B]$1B, which is the target qubit, in the two-qubit operation illustrated in Fig. 9 increases.

Fig. 10B illustrates the state illustrated in Fig. 10A by an energy level. The error of the operating frequency $f_D$ with respect to the design value appears as an error with respect to the design value at the energy level of the state e of the qubit $[Q_D]$. When the energy level of the state e of the qubit $[Q_D]$ deviates from the design value, a difference $\Delta E$ between the energy level of the state e of the qubit $[Q_D]$ and the energy level of the state e of the qubit $[Q_B]$ increases. In this case, as illustrated in Fig. 9, a case where a two-qubit operation in which the qubit $[Q_D]$1D is the control qubit and the qubit $[Q_B]$1B is the target qubit is performed will be considered. The relationship between the difference $\Delta f_{BD}$ between the operating frequency $f_D$ of the qubit $[Q_D]$1D, which is the control qubit, and the operating frequency $f_B$ of the qubit $[Q_B]$1B, which is the target qubit, and an operating frequency $f_{CNOT}$ in the two-qubit operation is expressed by the following Expression (1).

$$f_{CNOT} \propto 1/\Delta f_{BD} \qquad (1)$$

As is clear from Expression (1), as $\Delta f_{BD}$ increases, the operating frequency $f_{CNOT}$ in the two-qubit operation decreases. As a result, the time required for the two-qubit operation becomes longer. When the time required for the two-qubit operation becomes longer than the coherence time of the qubit, the two-qubit operation is unstable. As described above, in a case where the operating frequency between two qubits disposed adjacent to each other is excessively deviated, an error in which the two-qubit operation is unstable may occur. This type of error is referred to as a "second error". Among the four qubits disposed at the positions corresponding to the four vertices of the square, two qubits disposed at both ends of each side of the square correspond to "two qubits disposed adjacent to each other".

As described above, when the operating frequency of any one of the four qubits 1 constituting the basic unit 110 deviates from the design value, an error may occur in which the gate operation is unstable. Since the operating frequency of the qubit 1 has a correlation with the magnitude of the resistance of the Josephson element 4 (see Expression (4)), the operating frequency of the qubit 1 can be adjusted so as to approach the design value by adjusting the magnitude of the resistance of the Josephson element 4. As a result, the occurrence of an error can be suppressed. The magnitude of the resistance of the Josephson element 4 is the magnitude of the resistance at the Josephson junction.

Laser annealing is known as a technique for adjusting the magnitude of the resistance of the Josephson element 4. The laser annealing is a technique of locally heating the Josephson junction with a laser to promote formation of an insulating film and increase the resistance value of the Josephson element.

In order to suppress the occurrence of errors due to the deviation in the operating frequency, a method is conceivable in which the resistance of the Josephson element is measured for all the qubits constituting the quantum device, and laser annealing is performed for all the qubits for which the measured value of the resistance is out of the allowable range. However, in this method, the number of qubits to be subjected to laser annealing becomes enormous, and a large processing time is required. A processing system according to an embodiment of the disclosed technology described below efficiently adjusts an operating frequency.

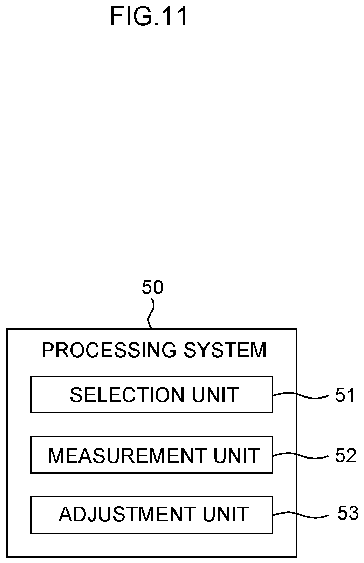

Fig. 11 is a block diagram illustrating an example of a functional configuration of a processing system 50 according to an embodiment of the disclosed technology. The processing system 50 is a system used for manufacturing the quantum device 100. The processing system 50 includes a selection unit 51, a measurement unit 52, and an adjustment unit 53.

The selection unit 51 selects, as the object of measurement from among the four qubits 1 constituting the basic unit 110, some qubits having a relatively high frequency of errors that may occur when a gate operation for applying a control signal corresponding to the operating frequency of the target qubits is performed. The measurement unit 52 measures the resistance of the Josephson element 4 for some qubits selected by the selection unit 51 among the four qubits 1 constituting the basic unit. The adjustment unit 53 adjusts the magnitude of the resistance of the Josephson element 4 for the qubit 1 in which the measured value of the resistance of the Josephson element is not within the predetermined range. Hereinafter, each of the above-described functional units of the processing system 50 will be described in detail.

The selection unit 51 performs a simulation for determining the presence or absence of the occurrence of the error when the operating frequency is varied from the design value for the four qubits 1 constituting the basic unit 110. The selection unit 51 performs the simulation a plurality of times while changing the combination of the operating frequencies of the four qubits 1 constituting the basic unit 110. The simulation method is as follows.

First, the maximum value and the minimum value of the operating frequency varying due to manufacturing variations and the like are obtained for each of the four qubits 1 constituting the basic unit 110. Using a standard deviation $\sigma$ of the operating frequency, for example, the design value $+\sigma$ may be set to the maximum value, and the design value $-\sigma$ may be set to the minimum value. The operating frequency of each of the four qubits 1 constituting the basic unit 110 is randomly set in a range from the obtained minimum value to the maximum value.

Next, it is determined whether or not a combination of operating frequencies randomly set in the four qubits 1 satisfies an error condition. In the present embodiment, the error conditions are the following two.

The first error condition is that a difference in operating frequency between two qubits disposed adjacent to each other among the four qubits constituting the basic unit 110 is smaller than a threshold. That is, it is determined that an error has occurred when the following Expression (2) is satisfied. In Expression (2), $f_j$ and $f_k$ are operating frequencies of two qubits disposed adjacent to each other. One of $f_j$ and $f_k$ corresponds to the g-e transition, and the other corresponds to the g-e transition, the g-f transition, or the e-f transition. In Expression (2), $f_s$ is a threshold and is appropriately set. Among the four qubits disposed at the positions corresponding to the four vertices of the square, two qubits disposed at both ends of each side of the square correspond to "two qubits disposed adjacent to each other". When the first error condition is satisfied, the first error described above may occur.

$$|f_j - f_k| < f_s \qquad (2)$$

The second error condition is that the difference in operating frequency between two qubits disposed adjacent to each other among the four qubits constituting the basic unit 110 is larger than the threshold. That is, it is determined that an error has occurred when the following Expression (3) is satisfied. In Expression (3), $f_j$ and $f_k$ are operating frequencies of two qubits disposed adjacent to each other. Both $f_j$ and $f_k$ correspond to the g-e transition. In Expression (3), $f_t$ is a threshold and is appropriately set. Among the four qubits disposed at the positions corresponding to the four vertices of the square, two qubits disposed at both ends of each side of the square correspond to "two qubits disposed adjacent to each other". When the second error condition is satisfied, the second error described above may occur.

$$|f_j - f_k| > f_t \qquad (3)$$

The selection unit 51 counts the frequency (that is, frequency of errors) of satisfying the error condition when the operating frequency is randomly changed for each of the four qubits 1 constituting the basic unit 110. The frequency of satisfying the error condition is nonuniform among the four qubits 1 constituting the basic unit 110. That is, the four qubits 1 constituting the basic unit 110 include those having a relatively high frequency and those having a relatively low frequency of satisfying the error condition. The selection unit 51 selects, as the object of measurement, some qubits having a relatively high frequency of satisfying the error condition in the above simulation among the four qubits 1 constituting the basic unit 110. The number of qubits selected as the object of measurement may be one, two, or three.

The selection unit 51 includes a computer that executes the above simulation. For example, information regarding upper and lower limit values and error conditions assuming manufacturing variations of the operating frequencies of the four qubits 1 constituting the basic unit 110 is input to the computer constituting the selection unit 51. The computer constituting the selection unit 51 executes the above simulation, for example, 30 times while changing the combination of the operating frequencies of the four qubits 1 constituting the basic unit 110 on the basis of the above input information, and outputs the frequency of errors for each qubit.

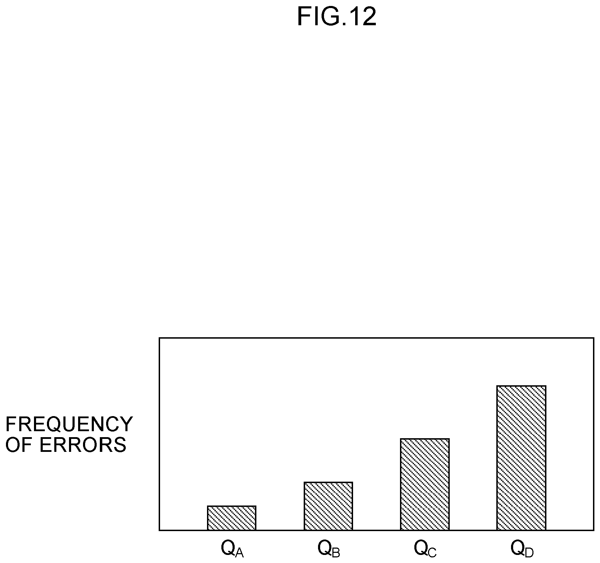

Fig. 12 is a diagram illustrating an example of the frequency of errors for each qubit obtained by performing the above simulation. In the example illustrated in Fig. 12, the selection unit 51 may select, for example, the qubit $[Q_D]1D$ having the highest frequency of errors as the object of measurement.

The measurement unit 52 measures the resistance of the Josephson element 4 for some of the qubits 1 selected by the selection unit 51 among the four qubits 1 constituting the basic unit 110. The measurement unit 52 performs similar measurement for each of the plurality of basic units 110 included in the quantum device 100. The measurement unit 52 specifies the qubit 1 whose measured value of resistance is lower than a threshold, and marks the qubit 1.

The relationship between a resistance value $R_N$ of the Josephson element 4 and an operating frequency $f_q$ of the qubit 1 is expressed by the following Expression (4). As is clear from Expression (4), the operating frequency $f_q$ of the qubit 1 increases as the resistance value $R_N$ of the Josephson element 4 decreases. The resistance value $R_N$ of the Josephson element 4 varies depending on manufacturing variations, and the operating frequency $f_q$ of the qubit 1 varies accordingly. By performing the above-described threshold determination on the measured value of the resistance of the Josephson element 4, it is possible to specify the qubit 1 in which the operating frequency deviates to the high frequency side beyond the allowable range with respect to the design value.

[Mathematical Formula 1]

$$f_q \propto \frac{1}{\sqrt{R_N}} \qquad \cdots \qquad (4)$$

The adjustment unit 53 adjusts the resistance value of the Josephson element 4 by performing laser annealing on the qubit 1 marked by the measurement unit 52, that is, the qubit 1 in which the measured value of the resistance of the Josephson element 4 is lower than the threshold.

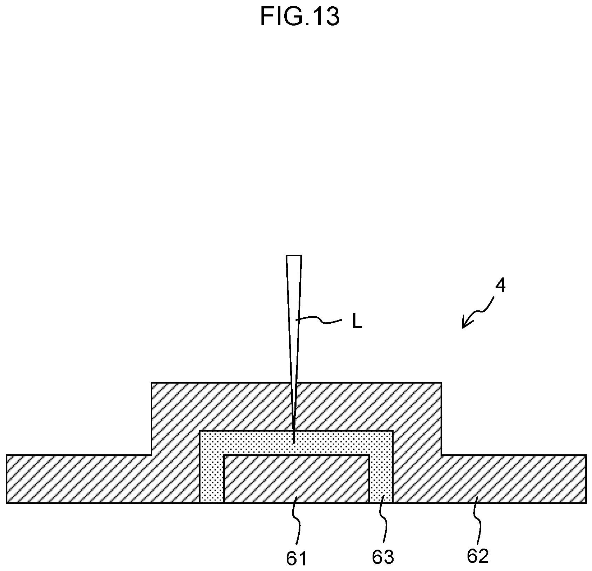

Fig. 13 is a cross-sectional view schematically illustrating laser annealing for the Josephson element 4. The Josephson element 4 has superconductor layers 61 and 62 and an insulator layer 63 sandwiched between the superconductor layers 61 and 62. The material of the superconductor layers 61 and 62 is, for example, Al, and the material of the insulator layer 63 is, for example, $AlO_x$. The laser annealing is a technique of locally heating the Josephson junction with the laser L to promote the formation of the insulator layer 63 and increase the resistance value of the Josephson element 4. By increasing the resistance value of the Josephson element 4, it is possible to adjust the operating frequency of the qubit 1 in a direction of decreasing the operating frequency. By performing the laser annealing on the qubit 1 in which the measured value of the resistance of the Josephson element 4 is lower than the threshold, the operating frequency of the qubit 1 in which the operating frequency exceeds the allowable range with respect to the design value and deviates to the high frequency side can be brought close to the design value.

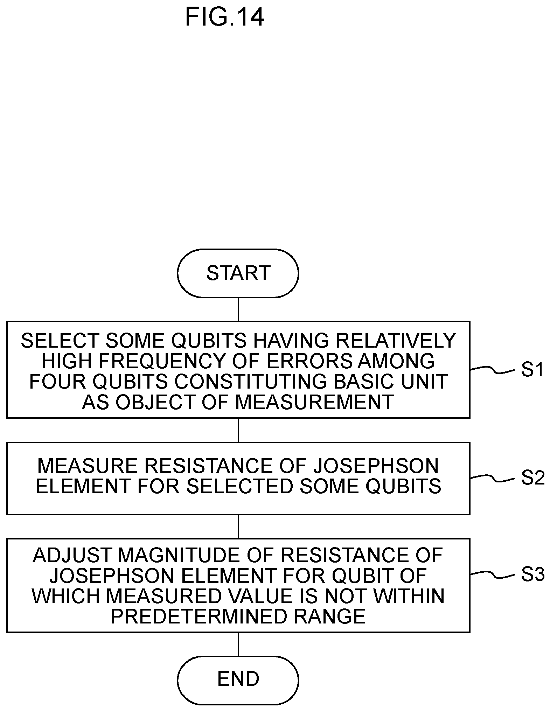

Fig. 14 is a flowchart illustrating an example of a flow of processing performed by the processing system 50. In Step S1, the selection unit 51 selects some of the qubits 1 having a relatively high frequency of errors among the four qubits 1 constituting the basic unit 110 as the object of measurement. The error can occur when the gate operation is performed to transition the energy level of the target qubit to a prescribed state, and the gate operation applies the control signal according to the operating frequency of the target qubit.

The selection unit 51 performs a simulation for determining the presence or absence of the occurrence of the error when the operating frequency is varied from the design value for the four or more qubits 1 constituting the basic unit 110. The selection unit 51 performs the simulation a plurality of times while changing the combination of the operating frequencies of the four qubits 1 constituting the basic unit 110. The selection unit 51 selects, as the object of measurement, some of the qubits 1 having a relatively high frequency at which it is determined that an error has occurred in the above simulation.

In Step S2, the measurement unit 52 measures the resistance of the Josephson element 4 for some qubits selected in Step S1 among the four qubits 1 constituting the basic unit.

In Step S3, the adjustment unit 53 adjusts the magnitude of the resistance of the Josephson element 4 for a qubit of which the measured value of the resistance of the Josephson element 4 is not within the predetermined range. The adjustment unit 53 adjusts the magnitude of the resistance by performing laser annealing on the qubit whose measured value of the resistance of the Josephson element 4 is not within a predetermined range. As a result, the operating frequency of the qubit is adjusted to approach the design value.

According to the processing system 50 according to the embodiment of the disclosed technology, the qubits to be adjusted in the operating frequency are limited to some qubits having a relatively high frequency of errors among the four qubits constituting the basic unit. As a result, the number of targets can be suppressed as compared with a case where all the four qubits constituting the basic unit are set as the operating frequency adjustment targets. That is, according to the processing system 50 according to the embodiment of the disclosed technology, it is possible to efficiently adjust the operating frequency of the qubits.

Note that, in the above description, a case has been exemplified where some qubits having a relatively high frequency of determination that an error has occurred in simulation are selected as the object of measurement, but the disclosed technology is not limited to this mode. Among the four or more qubits 1 constituting the basic unit, a qubit having the highest operating frequency may be selected as the object of measurement. This is because it has been found in the above simulation that the frequency of errors of the qubit having the highest operating frequency tends to be the highest.

[Second Embodiment]

The response signal indicating the state of the qubit 1 is read from the readout electrode 23. The read response signal is a signal having substantially the same frequency as the operating frequency of the qubit 1, and is amplified by a Josephson parametric amplifier (hereinafter referred to as JPA). JPA has the advantage that the amplification noise is as small as the quantum limit, while it has the disadvantage that the amplification band is narrow. The amplification band of JPA may deviate from the design value due to manufacturing variation. When the amplification band deviates from the design value, the frequency of the response signal may deviate from the amplification band of the JPA.

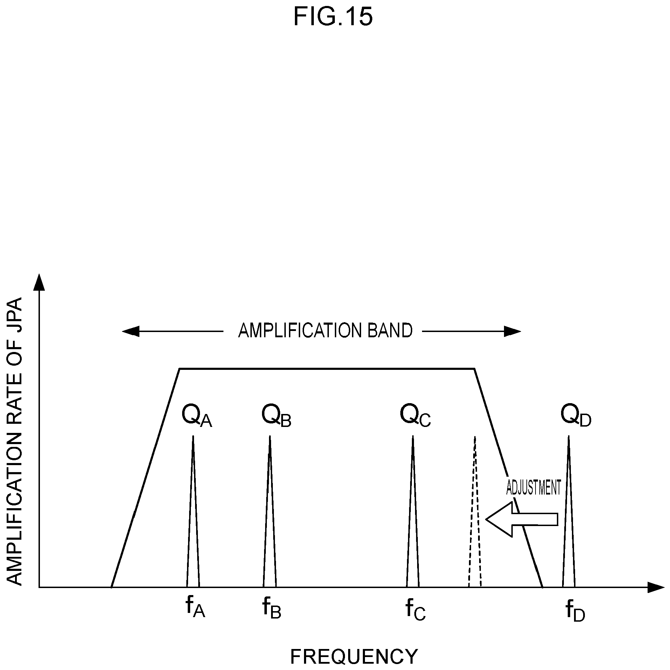

As illustrated in Fig. 15, the processing system 50 according to the second embodiment of the disclosed technology adjusts an operating frequency of a qubit whose operating frequency is out of an amplification band of JPA so as to fall within the amplification band of JPA. In the example illustrated in Fig. 15, a case where the operating frequency of the qubit $[Q_D]$1D having the highest design value of the operating frequency is adjusted to fall within the amplification band of JPA is exemplified. Note that, among the four qubits 1 constituting the basic unit 110, two or three qubits 1 having a relatively high design value of the operating frequency may be set as the operating frequency adjustment targets.

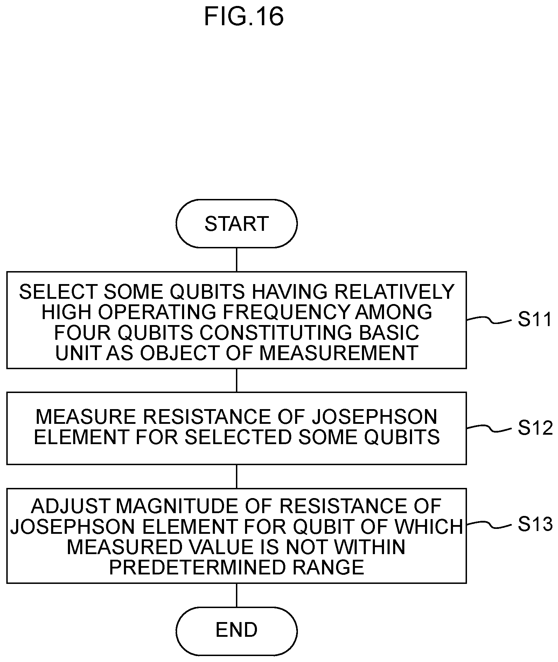

Fig. 16 is a flowchart illustrating an example of a flow of processing performed by the processing system 50 according to the second embodiment. In Step S11, the selection unit 51 selects some qubits having a relatively high design value of the operating frequency among the four qubits 1 constituting the basic unit 110 as the object of measurement. The number of qubits selected as the object of measurement may be any of one, two, and three.

In Step S12, the measurement unit 52 measures the resistance of the Josephson element 4 for some qubits selected in Step S11 among the four qubits 1 constituting the basic unit.

In Step S13, the adjustment unit 53 adjusts the magnitude of the resistance of the Josephson element 4 for a qubit of which the measured value of the resistance of the Josephson element 4 is not within the predetermined range. The predetermined range is determined by a value obtained by converting the amplification band of JPA into the resistance value of the Josephson element. The adjustment unit 53 adjusts the magnitude of the resistance by performing laser annealing on the qubit whose measured value of the resistance of the Josephson element 4 is not within a predetermined range. As a result, the operating frequency of the qubit is adjusted to fall within the amplification band of JPA.

According to the processing system 50 according to the second embodiment of the disclosed technology, it is possible to adjust an operating frequency of a qubit whose operating frequency is out of an amplification band of JPA so as to fall within the amplification band of JPA.

Note that, in the first and second embodiments described above, the case where the basic unit 110 includes the four qubits 1 has been exemplified, but the number of qubits 1 constituting the basic unit 110 may be three or five or more.

List of the Reference Symbols

| 1, 1A, 1B, 1C, 1D | qubit |
|---|---|
| 4 | Josephson element |
| 50 | processing system |
| 51 | selection unit |
| 52 | measurement unit |
| 53 | adjustment unit |
| 100 | quantum device |
| 110 | basic unit |

**Claims**

1. A method for manufacturing a quantum device including, as a basic unit, a plurality of three or more qubits each including a Josephson element and having an operating frequency correlated with a magnitude of resistance of the Josephson element, the qubits having different operating frequencies from each other, the method comprising:

   a first step of selecting, as an object of measurement from among the plurality of qubits, a first qubit with a relatively high frequency of errors that occur when performing a gate operation for causing an energy level of a target qubit to transition to a prescribed state, the gate operation applying a control signal according to an operating frequency of the target qubit;
   a second step of measuring a resistance of the Josephson element of the first qubit selected in the first step from among the plurality of qubits; and
   a third step of adjusting a magnitude of the resistance of the Josephson element of the first qubit based on a measured value of the resistance.

2. The method according to claim 1, wherein the first step includes

   performing a simulation for determining presence or absence of occurrence of the error in a case where the operating frequency is varied from a design value for the plurality of qubits a plurality of times while changing a combination of the operating frequencies of the plurality of qubits, and
   selecting, as the object of measurement, the first qubit having a relatively high frequency of determining that the error has occurred in the simulation.

3. The method according to claim 2, wherein in the simulation, when a difference in operating frequency between two qubits disposed adjacent to each other among the plurality of qubits is smaller than a threshold, it is determined that the error has occurred.

4. The method according to claim 2, wherein in the simulation, when a difference in operating frequency between two qubits disposed adjacent to each other among the plurality of qubits is larger than a threshold, it is determined that the error has occurred.

5. The method according to claim 1, wherein in the first step, a qubit having the highest operating frequency among the plurality of qubits is selected as the object of measurement.

6. The method according to any one of claims 1 to 5, wherein in the third step, laser annealing is performed on the first qubit when the measured value is not within a predetermined range.

7. A processing system of a quantum device including, as a basic unit, a plurality of three or more qubits each including a Josephson element and having an operating frequency correlated with a magnitude of resistance of the Josephson element, the qubits having different operating frequencies from each other, the processing system comprising:

   a selection unit that selects, as an object of measurement from among the plurality of qubits, a first qubit with a relatively high frequency of errors that occur when performing a gate operation for causing an energy level of a target qubit to transition to a prescribed state, the gate operation applying a control signal according to an operating frequency of the target qubit;
   a measurement unit that measures a resistance of the Josephson element of the first qubit selected in the selection unit from among the plurality of qubits; and
   an adjustment unit that adjusts a magnitude of the resistance of the Josephson element of the first qubit based on a measured value of the resistance.

8. The processing system according to claim 7, wherein the selection unit

> performs a simulation for determining presence or absence of occurrence of the error in a case where the operating frequency is varied from a design value for the plurality of qubits a plurality of times while changing a combination of the operating frequencies of the plurality of qubits, and
> selects, as the object of measurement, the first qubit having a relatively high frequency of determining that the error has occurred in the simulation.

9. The processing system according to claim 8, wherein when a difference in operating frequency between two qubits disposed adjacent to each other among the plurality of qubits is smaller than a threshold in the simulation, the selection unit determines that the error has occurred.

10. The processing system according to claim 8, wherein when a difference in operating frequency between two qubits disposed adjacent to each other among the plurality of qubits is larger than a threshold in the simulation, the selection unit determines that the error has occurred.

11. The processing system according to claim 7, wherein the selection unit selects a qubit having the highest operating frequency among the plurality of qubits as the object of measurement.

12. The processing system according to any one of claims 7 to 11, wherein the adjustment unit performs laser annealing on the first qubit when the measured value is not within a predetermined range.

13. A method for manufacturing a quantum device including, as a basic unit, a plurality of three or more qubits each including a Josephson element and having an operating frequency correlated with a magnitude of resistance of the Josephson element, the qubits having different operating frequencies from each other, the method comprising:

> a first step of selecting, as an object of measurement, a first qubit having a relatively high design value of an operating frequency from among the plurality of qubits; and
> a second step of measuring a resistance of the Josephson element for the first qubit selected in the first step among the plurality of qubits; and
> a third step of adjusting a magnitude of the resistance of the Josephson element of the first qubit based on a measured value of the resistance of the Josephson element.

## FIG.1

# FIG.2

# FIG.3

FIG.4

ENERGY LEVEL STRUCTURE

# FIG.5

110

70MHz

$f_A$:5000MHz $\longleftrightarrow$ $f_B$:5070MHz

$Q_A$ $Q_B$

1A 1B

140MHz 140MHz

1C 1D

$Q_C$ $Q_D$

$f_C$:5140MHz $\longleftrightarrow$ $f_D$:5210MHz

70MHz

# FIG.6

ONE-QUBIT OPERATION

110

$f_A$: 5000MHz  $f_B$: 5070MHz

$Q_A$  $Q_B$

1A  1B

CONTROL
SIGNAL
5210MHz

1C  1D

$Q_C$  $Q_D$  TARGET QUBIT

$f_C$: 5140MHz  $f_D$: 5210MHz

FIG.7A

FIG.7B

FIG.8A

FIG.8B

# FIG.9

TWO-QUBIT OPERATION

$f_A$:5000MHz

110

$f_B$:5070MHz

$Q_A$ ———————— $Q_B$  TARGET QUBIT

1A  1B

CONTROL
SIGNAL
5070MHz

1C  1D

$Q_C$ ———————— $Q_D$  CONTROL QUBIT

$f_C$:5140MHz

$f_D$:5210MHz

FIG.10A

FIG.10B

# FIG.11

50

PROCESSING SYSTEM

| SELECTION UNIT | 51 |
| MEASUREMENT UNIT | 52 |
| ADJUSTMENT UNIT | 53 |

FIG.12

FREQUENCY
OF ERRORS

$Q_A$    $Q_B$    $Q_C$    $Q_D$

# FIG.13

61    63    62

# FIG.14

```
      ┌─────────────┐
      │    START    │
      └─────────────┘
             │
┌────────────────────────────────────┐
│  SELECT SOME QUBITS HAVING RELATIVELY │
│  HIGH FREQUENCY OF ERRORS AMONG       │  ∿ S1
│  FOUR QUBITS CONSTITUTING BASIC UNIT  │
│     AS OBJECT OF MEASUREMENT          │
└────────────────────────────────────┘
             │
┌────────────────────────────────────┐
│   MEASURE RESISTANCE OF JOSEPHSON    │
│  ELEMENT FOR SELECTED SOME QUBITS     │  ∿ S2
└────────────────────────────────────┘
             │
┌────────────────────────────────────┐
│  ADJUST MAGNITUDE OF RESISTANCE OF    │
│   JOSEPHSON ELEMENT FOR QUBIT OF      │  ∿ S3
│  WHICH MEASURED VALUE IS NOT WITHIN   │
│       PREDETERMINED RANGE             │
└────────────────────────────────────┘
             │
      ┌─────────────┐
      │     END     │
      └─────────────┘
```

# FIG.15

# FIG.16

START

SELECT SOME QUBITS HAVING RELATIVELY HIGH OPERATING FREQUENCY AMONG FOUR QUBITS CONSTITUTING BASIC UNIT AS OBJECT OF MEASUREMENT — S11

MEASURE RESISTANCE OF JOSEPHSON ELEMENT FOR SELECTED SOME QUBITS — S12

ADJUST MAGNITUDE OF RESISTANCE OF JOSEPHSON ELEMENT FOR QUBIT OF WHICH MEASURED VALUE IS NOT WITHIN PREDETERMINED RANGE — S13

END

## INTERNATIONAL SEARCH REPORT

| International application No. |
|---|
| **PCT/JP2023/028645** |

### A. CLASSIFICATION OF SUBJECT MATTER

*H10N 60/01*(2023.01)i; *H10N 60/12*(2023.01)i
FI: H10N60/01 J; H10N60/01 K; H10N60/12 A

According to International Patent Classification (IPC) or to both national classification and IPC

### B. FIELDS SEARCHED

Minimum documentation searched (classification system followed by classification symbols)

H10N60/01; H10N60/12

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | CN 115692195 A (ORIGIN QUANTUM COMPUTING TECHNOLOGY CO., LTD.) 03 February 2023 (2023-02-03) paragraphs [0035]-[0036], [0041]-[0042] | 13 |
| Y | | 1, 5-7, 11-12 |
| A | | 2-4, 8-10 |
| Y | US 2020/0287119 A1 (BROOKHAVEN SCIENCE ASSOCIATES, LLC) 10 September 2020 (2020-09-10) paragraph [0055] | 1, 5-7, 11-12 |
| A | | 2-4, 8-10, 13 |
| Y | US 2022/0006458 A1 (IQM FINLAND OY) 06 January 2022 (2022-01-06) paragraph [0003] | 1, 5-7, 11-12 |
| A | | 2-4, 8-10, 13 |

☑ Further documents are listed in the continuation of Box C.　　☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **06 September 2023** | **19 September 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**

| International application No. |
| --- |
| **PCT/JP2023/028645** |

### C.    DOCUMENTS CONSIDERED TO BE RELEVANT

| Category* | Citation of document, with indication, where appropriate, of the relevant passages | Relevant to claim No. |
| --- | --- | --- |
| Y | US 2019/0165243 A1 (INTERNATIONAL BUSINESS MACHINES CORPORATION) 30 May 2019 (2019-05-30) paragraph [0030], fig. 3A | 6, 12 |
| A | | 1-5, 7-11, 13 |

Form PCT/ISA/210 (second sheet) (January 2015)

## INTERNATIONAL SEARCH REPORT
**Information on patent family members**

International application No.

**PCT/JP2023/028645**

| Patent document cited in search report | | | Publication date (day/month/year) | Patent family member(s) | | | Publication date (day/month/year) |
|---|---|---|---|---|---|---|---|
| CN | 115692195 | A | 03 February 2023 | (Family: none) | | | |
| US | 2020/0287119 | A1 | 10 September 2020 | (Family: none) | | | |
| US | 2022/0006458 | A1 | 06 January 2022 | EP | 3937091 | A1 | |
| | | | | CN | 113902117 | A | |
| | | | | TW | 202219847 | A | |
| | | | | KR 10-2023-0034388 | | A | |
| US | 2019/0165243 | A1 | 30 May 2019 | (Family: none) | | | |

Form PCT/ISA/210 (patent family annex) (January 2015)

**REFERENCES CITED IN THE DESCRIPTION**

**Patent documents cited in the description**

- US 20190165244

- JP 2021535592 A